# FASCICULE DE BREVET EUROPEEN

(11) **EP 2 671 250 B1**
(45) Date de publication et mention de la délivrance du brevet: **05.06.2019**
(21) Numéro de dépôt: 12708562.9
(22) Date de dépôt: 31.01.2012
(51) Int. Cl.: H01L 21/60, H01L 23/485, H01L 21/98, H01L 25/065, H01L 21/56

(54) **PROCÉDÉ DE FABRICATION DE DEUX SUBSTRATS RELIÉS PAR AU MOINS UNE CONNEXION MÉCANIQUE ET ÉLECTRIQUEMENT CONDUCTRICE ET STRUCTURE OBTENUE**
VERFAHREN ZUR HERSTELLUNG ZWEIER DURCH MINDESTENS EINE MECHANISCHE UND ELEKTRISCH LEITFÄHIGE VERBINDUNG VERBUNDENER SUBSTRATE UND DADURCH GEWONNENE STRUKTUR
METHOD FOR MANUFACTURING TWO SUBSTRATES CONNECTED BY AT LEAST ONE MECHANICAL AND ELECTRICALLY CONDUCTIVE CONNECTION AND THE STRUCTURE OBTAINED

(30) Priorité: 02.02.2011 FR 1100327
(43) Date de publication de la demande: 11.12.2013
(73) Titulaire: Commissariat à l'Énergie Atomique et aux Énergies Alternatives, 75015 Paris (FR)
(72) Inventeur: SOURIAU, Jean-Charles, 38120 Saint Egrève (FR)
(74) Mandataire: Talbot, Alexandre
(86) Numéro de dépôt international: PCT/FR2012/000042
(87) Numéro de publication internationale: WO 2012/104507

(56) Documents cités:
- FR-A1- 2 928 033
- JP-A- 2010 287 640
- US-A1- 2002 104 873
- US-A1- 2007 152 331
- US-A1- 2008 146 071

## Description

### Domaine technique de l'invention

L'invention est relative à un procédé de solidarisation de deux substrats.

### État de la technique

Dans le domaine des puces électroniques, il est courant d'utiliser différentes puces élémentaires incorporant des technologies et des fonctions différentes afin de former, au final, un circuit complexe qui répond à des besoins prédéfinis.

Dans certains cas particuliers, une ou plusieurs puces sont réalisées spécifiquement pour être utilisées dans un circuit final donné. Dans ces conditions, les particularités de chaque puce sont prises en compte lors de leur réalisation. Ceci permet d'obtenir la synergie attendue entre les différents composants. Cependant, il faut reconnaître que cette approche est très limitée car elle est coûteuse. En effet, une ou plusieurs puces sont réalisées « sur mesure » pour le circuit final ce qui limite voire supprime leur utilisation dans d'autres circuits.

Afin de réduire les coûts de réalisation, il est très avantageux de prendre des puces déjà existantes et de les assembler afin de profiter des spécificités de chacune des puces. Il existe alors des enjeux importants dans le domaine de l'interconnexion des puces afin d'obtenir un dispositif final fonctionnel et de taille raisonnable.

Afin de diminuer la distance séparant deux puces, il est proposé de réaliser la connexion de ces deux éléments au moyen d'un composé intermétallique.

Comme illustré aux figures 1 à 3, une première zone 1 de contact plane est formée à la surface d'un premier substrat 2. La première zone 1 de contact est réalisée dans un premier matériau métallique. Une seconde zone 3 de contact plane est formée à la surface d'un second substrat 4. La seconde zone 3 de contact est réalisée dans un second matériau métallique. Les deux zones 1 et 3 sont mises en contact (figure 2) et subissent un traitement thermique qui forme un composé intermétallique 5 à l'interface entre les deux matériaux métalliques (figure 3).

Comme le composé intermétallique se déforme assez mal plastiquement, cette architecture est sujette à des ruptures de la connexion sous l'effet de contraintes mécaniques. La contrainte mécanique provient, par exemple, de la différence de coefficient de dilatation entre les différents matériaux métalliques. On constate que la tenue dans le temps de ce dispositif n'est pas satisfaisante.

La publication de Saint-Patrice et al. (« New Reflow Soldering and Tip in Buried Box (TB2) Technique for Ultrafine Pitch Megapixels Imaging Array » Electronic Components and Technology Conférence, May 2008 ECTC 2008) décrit un procédé de solidarisation de deux substrats au moyen d'une bille d'indium à l'intérieur de laquelle un tube creux est enfoncé. Des essais ont été réalisés avec une couverture du tube creux par une couche d'or et sans cette couverture. Différents essais ont été réalisés avec cette architecture, sans pourvoir montrer une amélioration des performances mécaniques de ce genre de structure.

Le document US 2002/0104873 A1 et le document US 2007/0152331 A1 divulguent des procédés d'assemblage selon lesquels chaque plot disposé sur un premier substrat est enfoncé dans une bille de soudure disposée sur un second substrat et une couche continue en matériau intermétallique est formée le long de l'interface entre les plots et les billes.

Le document US 2008/0146071 A1 divulgue un procédé d'assemblage selon lequel plusieurs plots disposés sur la même plage de contact sur un premier substrat sont enfoncés dans la même bille de soudure disposée sur un second substrat.

### Objet de l'invention

On constate qu'il existe un besoin de prévoir un dispositif ayant une meilleure tenue mécanique ainsi qu'un procédé de réalisation de ce type de dispositif qui soit facile à mettre en oeuvre.

On tend à satisfaire ce besoin au moyen d'un dispositif selon la revendication qui comporte notamment
- un premier substrat muni d'une zone d'accueil en premier matériau métallique,
- un deuxième substrat muni d'une zone d'insertion,
- la zone d'insertion comportant une surface de base à partir de laquelle au moins deux plots en second matériau métallique font saillie,
- les plots s'enfonçant dans la même zone d'accueil pour former une connexion mécanique et électrique entre le premier et le second substrat,
- une couche d'un composé intermétallique en premier et second matériaux métalliques séparant chacun des au moins deux plots de la zone d'accueil, les au moins deux couche en composé métallique étant séparées par une zone en premier matériau métallique,
- la surface de base étant formée par un troisième matériau métallique, les plots s'enfonçant à l'intérieur de la surface de base et un second composé intermétallique des troisième et second matériaux métalliques séparant chacun des au moins deux plots du troisième matériau métallique.

Un tel dispositif peut être obtenu au moyen d'un procédé de fabrication selon la revendication 1, qui comporte notamment les étapes suivantes :
- prévoir un premier substrat muni d'une zone d'accueil en premier matériau métallique et un second substrat muni d'une zone d'insertion comportant une surface de base et au moins deux plots en un second matériau métallique, les plots faisant saillie depuis la surface de base,
- appliquer une pression entre le premier substrat et le second substrat de manière à faire pénétrer les plots à l'intérieur de la zone d'accueil du premier substrat,
- faire réagir le premier matériau métallique avec le second matériau métallique de manière à former une couche continue d'un composé intermétallique à base des premier et second matériaux métalliques le long de l'interface entre les plots et la zone d'accueil, les au moins deux couches en composé intermétallique étant séparées par une zone en premier matériau métallique,
- la surface de base étant formée par un troisième matériau métallique, les plots pénétrant à l'intérieur de la surface de base lors de l'application de la pression, de manière que le troisième matériau métallique réagisse avec le second matériau métallique pour former un second composé intermétallique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

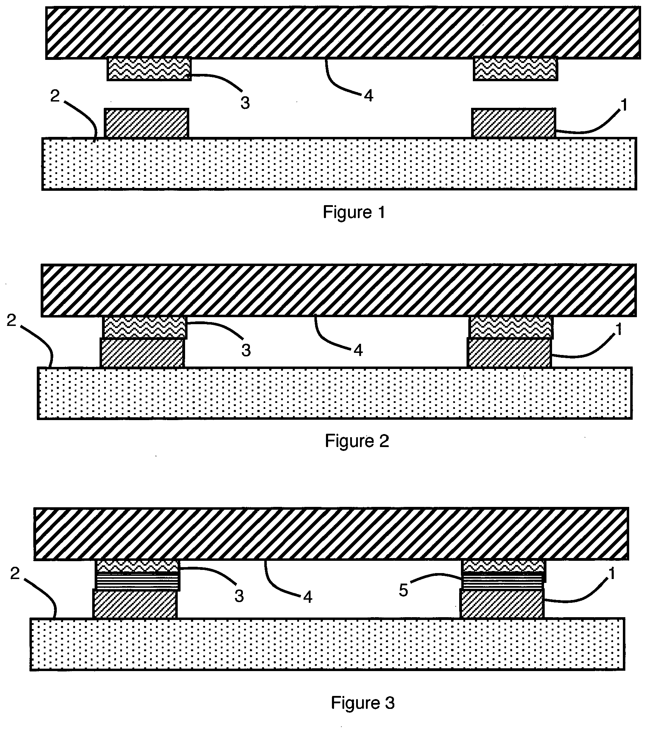

- les figures 1 à 3 représentent, de manière schématique, en vue de coupe des étapes successives de mise en oeuvre d'un premier procédé de l'art antérieur,

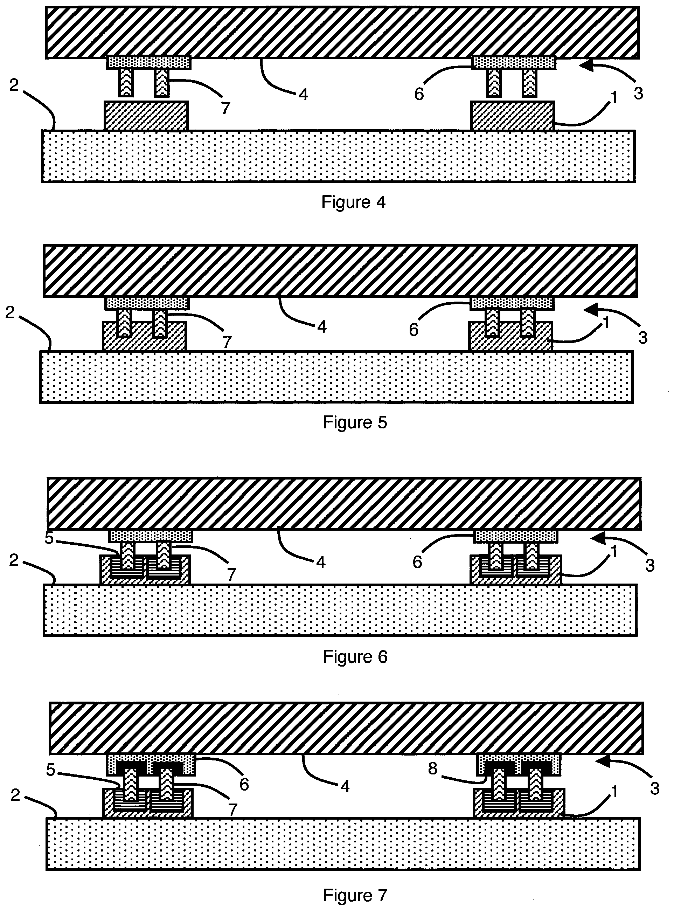

- les figures 4 à 6 représentent, de manière schématique, en vue de coupe des étapes successives de mise en oeuvre d'un deuxième procédé utile pour comprendre l'invention,
- la figure 7 représente, de manière schématique, en vue de coupe une première variante de réalisation de la structure du dispositif selon l'invention,

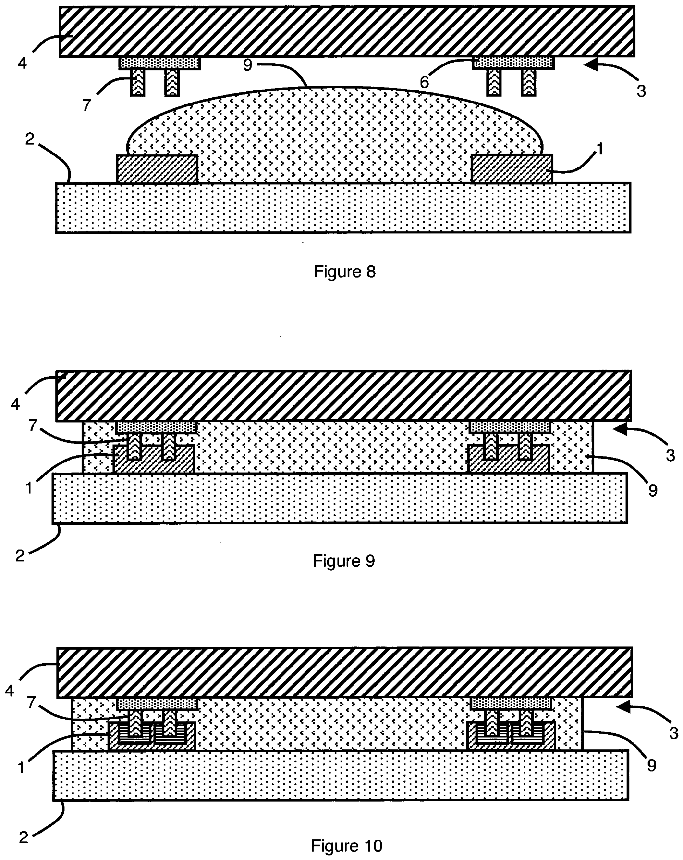

- les figures 8 à 10 représentent, de manière schématique, en vue de coupe des étapes successives de mise en oeuvre d'un troisième procédé utile pour comprendre l'invention,

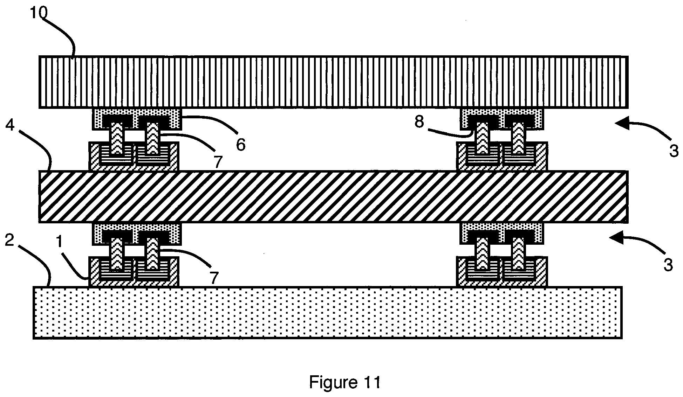

- la figure 11 représente, de manière schématique, en vue de coupe une seconde variante de réalisation de la structure du dispositif selon l'invention.

### Description de modes de réalisation préférentiels de l'invention

Comme illustré à la figure 4 selon un exemple utile pour comprendre le procédé de l'invention, un premier substrat 2 comporte une surface principale avec une connexion électrique formée par une zone d'accueil 1. La zone d'accueil 1 est formée par un premier matériau métallique. La zone d'accueil 1 présente avantageusement une surface libre plane. Cependant, dans certains modes de réalisation, la surface libre peut présenter une topographie de surface. La surface libre est une surface qui est découverte ou qui peut être recouverte par un matériau quelconque comme un oxyde.

Un second substrat 4 est utilisé et il comporte une surface principale avec une connexion électrique formée par une zone d'insertion 3. La zone d'insertion 3 présente une topographie de surface qui peut être représentée par une surface de base 6 sensiblement plane à la surface de laquelle un plot 7 fait saillie. Le plot 7 est formé par un second matériau métallique. Selon l'invention, le plot 7 et la surface de base 6 sont formés dans des matériaux différents. Le plot 7 est rendu solidaire du second substrat 4 par l'intermédiaire de la surface de base 6. Le plot 7 est en contact électrique avec le second substrat ou des dispositifs actifs disposés sur le second substrat 4 par l'intermédiaire de la surface de base 6. Le premier substrat et/ou le second substrat peuvent être une puce électronique, un substrat semi-conducteur vierge ou comportant des dispositifs actifs, une carte électronique également appelée « board », une plaque en verre ou en céramique ou un substrat flexible par exemple de type polymère incorporant ou non des dispositif actifs.

Si la zone d'accueil 1 est recouverte par une couche électriquement isolante ou une couche de nature différente, cette dernière est éliminée avant de réaliser la connexion avec la zone d'insertion ou alors la couche électriquement isolante ou de nature différente est percée par les plots 7 de manière à obtenir un contact intime entre le plot 7 et la zone d'accueil 1. Il en va de même si le plot 7 est recouvert par une couche électriquement isolante ou de nature différente.

Les premier 2 et second 4 substrats sont mis en regard de manière à permettre la connexion entre la zone d'accueil 1 et la zone d'insertion 3. La zone d'accueil 1 fait face à la zone d'insertion 3.

Comme illustré à la figure 5, une pression est appliquée sur les deux substrats 2 et 4 de manière à réaliser un contact intime entre la zone d'accueil 1 et la zone d'insertion 3. La zone d'insertion 3 s'enfonce au moins partiellement dans la zone d'accueil 1. La zone d'accueil 1 vient se déformer sous l'action de la pression exercée par la zone d'insertion 3. Dans un plan de coupe parallèle à la surface principale du premier substrat 2 et traversant la zone d'accueil 1, le plot 7 et la zone d'accueil 1 ont des surfaces complémentaires. Le plot est de préférence plein ce qui permet de mieux contrôler la formation du composé intermétallique.

Le premier matériau métallique est un matériau tendre qui autorise la pénétration du plot 7 en second matériau métallique sans se dégrader. Le second matériau métallique est un matériau dur qui pénètre à l'intérieur de la zone d'accueil 1 sans trop se déformer, ni se dégrader.

Le premier matériau métallique est un matériau dont la dureté est inférieure à celle du second matériau métallique. De manière préférentielle, Le premier matériau métallique présente une dureté Brinell inférieure ou égale à 60 MPa ou une dureté Mohs inférieure ou égale à 2. Une telle valeur limite permet de réaliser, de manière simple, une déformation de la zone d'accueil sans devoir appliquer des contraintes élevées dans le reste du substrat. Le premier matériau métallique est par exemple de l'étain, du plomb, de l'indium ou un alliage à base d'étain et/ou d'indium ou un alliage à base de l'un ou plusieurs de ces matériaux.

Le second matériau métallique présente avantageusement une dureté Brinell supérieure ou égale à 200MPa ou une dureté Mohs supérieure ou égale à 2,5. Une telle valeur limite permet de réaliser de manière simple une déformation de la zone de contact sans déformer la zone d'insertion 3, ni devoir appliquer des contraintes élevées dans le reste du substrat. Le second matériau métallique est, de préférence, du nickel ou du cuivre ou un alliage contenant du nickel et/ou du cuivre. Le second matériau métallique peut être encore avantageusement du fer, de l'antimoine, de l'or, du bismuth, de l'argent, du palladium ou du platine ou un alliage à base de l'un ou plusieurs de ces matériaux.

Il est possible d'utiliser indifféremment les matériaux cités avantageusement pour le premier matériau métallique en tant que matériau servant pour le second matériau métallique et inversement. Le choix des matériaux est fait principalement de manière à avoir un premier matériau métallique plus tendre que le second matériau métallique et ainsi autoriser la pénétration du plot 7 dans la zone d'accueil 1 ce qui est plus favorable à la création d'un intermétallique.

De manière préférentielle, le rapport de dureté entre le matériau du plot 7 d'insertion et le matériau de la zone d'accueil 1 est supérieur ou égal à 2 de manière à bien maîtriser l'enfoncement du plot. Le rapport de dureté est réalisé sur un même type de dureté, par exemple, la dureté vickers, la dureté Brinell ou la dureté Mohs.

Comme illustré à la figure 6, une fois le plot 7 d'insertion encastré dans la zone d'accueil 1, des conditions opératoires prédéterminées sont appliquées afin de faire réagir le premier matériau métallique avec le second matériau métallique. Le premier matériau métallique réagit avec le second matériau métallique afin de former un composé intermétallique 5 également appelé intermétallique. Un traitement thermique peut être appliqué pour faire réagir le premier matériau métallique avec le second matériau métallique à une température supérieure à la température ambiante. Dans certains modes de réalisation, la formation du composé intermétallique 5 peut commencer dès la mise en contact du plot 7 avec la zone d'accueil 1 et une certaine pression.

De manière classique, la vitesse de réaction augmente avec la température du traitement. Il est également possible d'obtenir ou d'accélérer la réaction entre les deux matériaux métalliques en maintenant la compression après que le plot 7 se soit enfoncé dans la surface d'accueil 1. Il est également possible de combiner ces deux derniers modes de réalisation.

Le composé intermétallique 5 est un matériau avec une alternance des atomes constitutifs qui forment une structure périodique et qui présente des propriétés mécaniques particulières. Le composé intermétallique est un alliage entre deux matériaux métalliques.

Si les premier et second matériaux métalliques sont en nickel et en étain, le matériau formé est, par exemple, le composé intermétallique Ni₃Sn, Ni₃Sn₂, Ni₃Sn₄ ou NiSn₃. Si la zone d'accueil 1 n'est plus en étain mais en indium, il est possible de former Ni₃In, NiIn, Ni₂In₃ ou Ni₃In₇. Si le plot est en cuivre, il est alors possible de former Cu₆Sn₅, Cu₃Sn, Cu₃In, Cu₉In₄. Différents composés intermétalliques 5 peuvent être formés à partir d'étain, de plomb et d'indium d'une part et de cuivre, nickel, fer, indium, antimoine, bismuth, argent, palladium et platine d'autre part. Le composé intermétallique 5 permet d'assurer une meilleure connexion mécanique en comparaison d'une simple connexion par emboîtement. Le composé intermétallique permet également le passage d'un courant électrique entre le premier substrat 2 et le second substrat 4.

Les premier et second matériaux et les conditions opératoires lors de l'introduction du plot 7 dans la zone d'accueil 1 et/ou du traitement thermique de formation du composé intermétallique 5 sont choisies de manière à éviter la formation d'un composé intermétallique 5 dont l'interdiffusion et la transformation de phases empêchent la formation d'un film continu à l'interface entre le plot 7 et la zone d'accueil 1. De telles conditions se produisent par exemple avec de l'or et de l'indium qui forment le composé AuIn₂ dont l'interdiffusion et la transformation de phases ont lieu à température ambiante ce qui entraîne une consommation complète du premier et/ou du deuxième matériau métallique. Cela entraîne également la formation du composé intermétallique dans le coeur du plot et/ou dans le coeur de la zone d'accueil 1 et non à l'interface entre ces deux éléments.

Le diamètre des plots et le volume de la zone d'accueil sont choisis de manière à ce que le composé intermétallique ne croît pas dans tout le volume de la zone d'accueil pendant la durée de vie de la structure. Cette précaution évite d'avoir la consommation complète du matériau formant la zone d'accueil et/ou le plot avec une fragilisation de la structure finale. Cela permet également à la structure d'être dépourvue d'une zone vide à l'intérieur du volume délimité par un plot creux ce qui est préjudiciable à la bonne tenue mécanique.

Le composé intermétallique 5 est formé à l'interface entre le premier matériau métallique et le second matériau métallique. Ainsi, le composé intermétallique 5 suit l'enfoncement du plot 7 à l'intérieur de la zone d'accueil 1. Le film en composé intermétallique 5 n'est plus plan comme dans l'art antérieur. Il présente des faces latérales, c'est-à-dire des faces non parallèles à la face principale du premier substrat 2. Le composé intermétallique suit la surface du plot 7 dans la zone d'accueil 1.

Le composé intermétallique 5 fait la séparation du second matériau métallique du plot 7 avec la zone d'accueil 1 en premier matériau ce qui a pour effet de renforcer la cohésion des deux substrats. La composante verticale du composé intermétallique 5 permet d'obtenir une meilleure résistance aux forces de cisaillements. La forme particulière de la couche en composé intermétallique 5 liée à l'enfoncement du plot 7 dans la zone d'accueil 1 permet d'obtenir, de manière générale, une connexion moins sensible aux contraintes mécaniques.

Dans un cas particulier de réalisation, le plot 7 s'enfonce et traverse la zone d'accueil 1, par s'exemple pour s'enfoncer dans le premier substrat 2. Dans ce cas de figure, le composé intermétallique 5 est formé à l'interface entre les deux matériaux métalliques et la partie du plot 7 qui est en contact avec le premier substrat 2 peut être dépourvue de composé intermétallique. Le matériau intermétallique forme un film continu à l'interface entre le premier matériau métallique et le second matériau métallique, mais il n'est pas présent hors de cette interface par exemple à l'interface entre le plot et le premier substrat.

De manière préférentielle, le composé intermétallique 5 empêche tout contact direct entre le plot 7 et la zone d'accueil 1 et évite ainsi la formation d'une zone mécaniquement plus fragile par exemple aux efforts de cisaillement.

Dans un mode de réalisation particulier envisageable, un traitement thermique est réalisé dès la mise en contact des deux substrats afin de faciliter la pénétration du plot dans la zone d'accueil 1. Le traitement thermique peut servir à ramollir la zone d'accueil 1 ce qui permet une meilleure pénétration dans la zone d'accueil 1. Le traitement thermique peut également à accélérer la vitesse de réaction pour former le composé intermétallique 5.

Dans un mode de réalisation particulier, le traitement thermique permet de faire fondre au moins partiellement la zone d'accueil 1. Cette fusion partielle permet d'accélérer la formation du composé intermétallique 5 et de réduire la pression à exercer entre les substrats 2 et 4.

Le traitement thermique appliqué à la structure est choisi de façon à maîtriser la mobilité des atomes des premier et second matériaux métalliques. Dans un mode de réalisation particulier, la température de la structure est augmentée afin de favoriser la mobilité des atomes des premier et second matériaux métalliques sans pour autant atteindre la fusion de la zone d'accueil. La modulation de la température de la structure durant la formation du composé intermétallique permet de maîtriser l'épaisseur du composé intermétallique.

Dans un mode de réalisation préférentielle, au moins 20% du volume initial du plot ne réagit pas avec le matériau métallique de la zone d'accueil. De cette manière, le plot 7 conserve un volume suffisant pour maintenir une bonne cohésion mécanique entre les différents éléments de la structure.

Comme illustré à la figure 7, la surface de base 6 de la zone d'insertion 3 est réalisée dans un troisième matériau métallique qui est un matériau tendre. Lors de l'application de la pression entre le premier 2 et le second 4 substrats, le plot 7 en second matériau métallique s'enfonce à l'intérieur du premier et du troisième matériaux métalliques. De ce fait, lors de l'application du traitement thermique, deux composés intermétalliques différents sont formés. Un premier composé intermétallique 5 est formé entre le premier et le second matériau métallique et un second composé intermétallique 8 est formé entre le troisième et le second matériau métallique. Le plot 7 est séparé de la zone d'accueil 1 et de la surface de base 6 par des composés intermétalliques 5, 8.

Les conditions opératoires, notamment le traitement thermique de formation du composé intermétallique 5, sont choisies pour éviter la dissolution du premier et/ou du second matériau métallique. Ainsi, la connexion mécanique et électrique entre le premier 2 et le second 4 substrats comporte une partie en premier matériau métallique, une partie en second matériau métallique et le composé intermétallique à l'interface.

Dans les exemples illustrés aux figures 4 à 11, plusieurs plots 7 sont agencés pour s'enfoncer dans une même zone d'accueil 1 monobloc. Les plots 7 sont suffisamment espacés les uns des autres de manière à ce qu'une partie du matériau de la zone d'accueil 1 ne réagisse pas entre deux plots 7 adjacents. A titre d'exemple, au moins deux plots 7 sont configurés pour s'enfoncer dans une même zone d'accueil 1. Au moins deux couches continues en composé intermétallique 5 sont formées dans la zone d'accueil 1 pour séparer chaque plot 7 du premier matériau de la zone d'accueil 1. Les deux couches en composé intermétallique sont séparées par une zone en premier matériau métallique selon un axe qui relie le premier plot 7 au deuxième plot 7. De manière avantageuse, la séparation entre les deux couches en composé 5 est complète.

De cette manière, dans un plan de coupe parallèle à la surface principale du premier et/ou du deuxième substrats, on observe que les deux zones en composé intermétallique 5 sont séparées par le premier matériau métallique de la zone d'accueil 1 comme cela est visible à la figure 6. Cette configuration permet de créer, entre les deux plots 7, une zone qui est moins dure. Cette partie de la zone d'accueil 1 peut se déformer plastiquement de manière à absorber les contraintes induites lors des chocs mécaniques et/ou thermiques. Ainsi, le plot 7 est séparé de la zone d'accueil 1 par le composé intermétallique 5 et deux zones adjacentes en composé intermétallique sont séparées par le premier matériau intermétallique de la zone d'accueil 1. De manière avantageuse, il y a continuité de la zone en premier matériau métallique dans la zone d'accueil, ce qui facilite l'absorption des contraintes.

Dans un autre exemple qui peut être combiné avec le mode de réalisation précédent et illustré à la figure 8, de la colle 9 est déposée sur un des substrats. Lors de la connexion des substrats par application d'une pression et du traitement thermique pour former le composé intermétallique 5, la colle réagit pour former un deuxième mode de solidarisation des substrats.

Comme illustré à la figure 9, la pression exercée pour enfoncer le plot 7 dans la zone d'accueil 1 permet d'étaler la colle 9 sur la surface des substrats. Comme illustré à la figure 10, le traitement thermique servant à former le composé intermétallique 5 permet de fluidifier la colle et/ou de réaliser la polymérisation.

Dans une variante de réalisation illustrée à la figure 11, un troisième substrat 10 est associé au premier 2 ou au second 4 substrat. Comme dans le mode de réalisation précédent, un des deux substrats comporte une zone d'accueil 1 et l'autre substrat comporte une zone d'insertion 3 avec un plot qui fait saillie. La zone d'accueil 1 et la zone d'insertion 3 sont mis en vis-à-vis et une pression est exercée de manière à ce que le plot 7 s'enfonce à l'intérieur de la zone d'accueil 1. Un traitement thermique est ensuite réalisé pour former un composé intermétallique 5. Ce cas particulier peut, bien entendu, être étendu à la connexion d'un plus grand nombre de substrats.

Il est possible d'utiliser les mêmes matériaux ou des matériaux différents entre les connexions des différents substrats.

Dans un mode de réalisation préférentiel, le même traitement thermique est utilisé pour former le composé intermétallique entre le premier 2 et le second 4 substrat et entre le troisième substrat et le premier 2 ou second 4 substrat.

Dans une autre variante de réalisation, le premier 2, le second 4 et le troisième 10 substrats sont associés de manière à ce que chaque zone d'accueil 1 soit en vis-à-vis d'une zone d'insertion 3. Une pression est appliquée sur l'ensemble de manière à faire pénétrer le plot 7 dans la zone d'accueil 1 associée. De cette manière, le plot 7 du second substrat 4 déforme la zone d'accueil 1 du premier substrat 2 en même temps qu'une action similaire est réalisée avec le troisième substrat 10. Le troisième substrat 10 peut être associé au premier 2 ou au second 4 substrat et il peut comporter une zone d'accueil 1 ou une zone d'insertion 3.

A titre d'exemple, le premier substrat 2 peut être associé au second 4 et au troisième 10 substrats qui se trouvent alors sur des faces principales opposées du premier substrat 2. Le second substrat 4 est séparé du troisième substrat 10 par le premier substrat 2. Dans un autre mode de réalisation, le second 4 et le troisième 10 substrats sont disposés sur la même face principale du premier substrat 2 et sont adjacents.

Plusieurs zones d'accueil 1 et/ou plusieurs zones d'insertion 3 peuvent être formées sur un même substrat. Ainsi, il est possible de former une zone d'accueil 1 à côté d'une zone d'insertion 3 sur la surface principale d'un substrat.

Dans un exemple qui peut être combiné avec le mode de réalisation précédent, le plot 7 en second matériau métallique et/ou la zone d'accueil 1 est recouverte par un matériau de couverture 11 métallique. Le matériau de couverture 11 est par exemple un matériau possible en tant que premier ou second matériau métallique. Ce qui lui permet d'être déformé lorsque le plot entre en contact avec la zone d'accueil 1. A titre d'exemple, le plot 7 et la zone d'accueil 1 sont recouvert par un matériau noble par exemple de l'or qui empêche l'oxydation du plot 7 et de la zone d'accueil 1. L'or est présent au moins partiellement entre le plot 7 et la zone d'accueil 1. L'or ne gêne pas la formation du composé intermétallique 5 entre le premier matériau et le second matériau et il peut former un autre composé intermétallique.

Cela permet de protéger les contacts électriques sur le premier 2 et le second 4 substrats en évitant la formation d'un oxyde électriquement isolant. Cela permet également de former une connexion électrique et mécanique fiable entre les deux substrats sans devoir éliminer préalablement la couche de recouvrement 11.

## Revendications

1. Procédé de solidarisation de deux substrats (2, 4) comportant les étapes suivantes :
- prévoir un premier substrat (2) muni d'une zone d'accueil (1) monobloc en premier matériau métallique et un second substrat (4) muni d'une zone d'insertion (3) comportant une surface de base (6) et au moins deux plots (7) en un second matériau métallique, les au moins deux plots (7) faisant saillie depuis la surface de base (6), la zone d'accueil (1) et la zone d'insertion (3) formant une connexion électrique,
- appliquer une pression entre le premier substrat (2) et le second substrat (4) de manière à faire pénétrer les au moins deux plots (7) à l'intérieur de la zone d'accueil (1) du premier substrat (2),
- faire réagir le premier matériau métallique avec le second matériau métallique de manière à former une couche continue d'un composé intermétallique (5) à base des premier et second matériaux métalliques le long de l'interface entre chaque plot (7) et la zone d'accueil (1), les au moins deux couches en composé intermétallique étant séparées par une zone en premier matériau métallique, la surface de base (6) étant formée par un troisième matériau métallique, les au moins deux plots (7) pénétrant à l'intérieur de la surface de base (6) lors de l'application de la pression, le troisième matériau métallique réagissant avec le second matériau métallique pour former un second composé intermétallique (8).

2. Procédé selon la revendication 1, **caractérisé en ce qu'**un traitement thermique est réalisé durant l'application de la pression pour faire réagir le premier matériau métallique avec le second matériau métallique et le second matériau métallique avec le troisième matériau métallique.

3. Procédé selon l'une des revendications 1 à 2, **caractérisé en ce que** le rapport de dureté entre le second matériau métallique et le premier matériau métallique est supérieur ou égal à deux.

4. Procédé selon la revendication 2 ou selon la revendication 3 dans le cas où elle dépend de la revendication 2, **caractérisé en ce que** le traitement thermique fait fondre le premier matériau métallique.

5. Procédé selon l'une quelconque des revendications 1 à 4, **caractérisé en ce qu'**un troisième substrat (10) est mis en contact avec le premier substrat (2) ou avec le second substrat (4) et **en ce que** soit le troisième substrat soit le substrat avec lequel il est mis en contact comporte une zone d'accueil (1) additionnelle, le substrat qui ne comporte pas ladite zone d'accueil additionnelle comportant une zone d'insertion (3) additionnelle, au moins un plot (7) additionnel de la zone d'insertion (3) additionnelle pénétrant la zone d'accueil (1) additionnelle lors de l'application d'une pression entre le premier substrat (2), le deuxième substrat (4) et le troisième substrat, un composé intermétallique (5) additionnel est formé entre les matériaux métalliques formant le plot (7) additionnel et la zone d'accueil (1) additionnelle.

6. Dispositif comportant :
- un premier substrat (2) muni d'une zone d'accueil (1) monobloc en premier matériau métallique, la zone d'accueil (1) formant une connexion électrique,
- un deuxième substrat (4) muni d'une zone d'insertion (3), la zone d'insertion (3) formant une connexion électrique,
- la zone d'insertion (3) comportant une surface de base (6) à partir de laquelle au moins deux plots (7) en un second matériau métallique font saillie,
- les au moins deux plots (7) étant enfoncés dans la même zone d'accueil (1) pour former une connexion mécanique et électrique entre le premier (2) et le second (4) substrat, où :
- la surface de base (6) est formée par un troisième matériau métallique, les au moins deux plots (7) sont enfoncés à l'intérieur de la surface de base (6) et séparés du troisième matériau métallique par un second composé intermétallique (8) des troisième et second matériaux métalliques et où le dispositif comporte une couche continue d'un composé intermétallique (5) des premier et second matériaux métalliques séparant chacun des au moins deux plots (7) de la zone d'accueil (1), les au moins deux couches dudit composé intermétallique étant séparées par une zone en premier matériau métallique.

## Patentansprüche

1. Verfahren zum festen Verbinden zweier Substrate (2, 4), wobei es die folgenden Schritte aufweist:
- Bereitstellen eines ersten Substrats (2), das mit einem einstückigen Aufnahmebereich (1) aus einem ersten metallischen Material versehen ist, und eines zweiten Substrats (4), das mit einem Einsteckbereich (3) versehen ist, welcher eine Grundfläche (6) und mindestens zwei Stifte (7) aus einem zweiten metallischen Material aufweist, wobei die mindestens zwei Stifte (7) aus der Grundfläche (6) hinausragen, wobei der Aufnahmebereich (1) und der Einsteckbereich (3) eine elektrische Verbindung bilden,
- Anwenden eines Drucks zwischen dem ersten Substrat (2) und dem zweiten Substrat (4), derart, dass die mindestens zwei Stifte (7) ins Innere des Aufnahmebereichs (1) des ersten Substrats (2) eindringen,
- Reagierenlassen des ersten metallischen Materials mit dem zweiten metallischen Material, sodass sich entlang der Grenzschicht zwischen jedem der Stifte (7) und dem Aufnahmebereich (1) eine durchgehende Schicht aus einer intermetallischen Verbindung (5) bildet, welche auf dem ersten und dem zweiten metallischen Material beruht,
wobei die mindestens zwei Schichten aus intermetallischer Verbindung durch einen Bereich aus dem ersten metallischen Material voneinander getrennt sind, wobei die Grundfläche (6) aus einem dritten metallischen Material gebildet ist, wobei die mindestens zwei Stifte (7) ins Innere der Grundfläche (6) eindringen, wenn der Druck angewendet wird, wobei das dritte metallische Material mit dem zweiten metallischen Material reagiert, um eine zweite intermetallische Verbindung (8) zu bilden.

2. Verfahren nach Anspruch 1, **dadurch gekennzeichnet, dass** eine Wärmebehandlung erfolgt, während der Druck angewendet wird, um das erste metallische Material mit dem zweiten metallischen Material sowie das zweite metallische Material mit dem dritten metallischen Material reagieren zu lassen.

3. Verfahren nach einem der Ansprüche 1 bis 2, **dadurch gekennzeichnet, dass** das Härteverhältnis zwischen dem zweiten metallischen Material und dem ersten metallischen Material mindestens zwei beträgt.

4. Verfahren nach Anspruch 2, oder nach Anspruch 3 falls dieser vom Anspruch 2 abhängig ist, **dadurch gekennzeichnet, dass** die Wärmebehandlung das erste metallische Material zum Schmelzen bringt.

5. Verfahren nach einem beliebigen der Ansprüche 1 bis 4, **dadurch gekennzeichnet, dass** ein drittes Substrat (10) mit dem ersten Substrat (2) oder mit dem zweiten Substrat (4) in Kontakt gebracht wird, und dadurch, dass entweder das dritte Substrat oder das Substrat, mit welchem es in Kontakt gebracht wird, einen zusätzlichen Aufnahmebereich (1) aufweist, wobei dasjenige Substrat, welches den zusätzlichen Aufnahmebereich nicht aufweist, einen zusätzlichen Einsteckbereich (3) aufweist, wobei mindestens ein zusätzlicher Stift (7) des zusätzlichen Einsteckbereichs (3) in den zusätzlichen Aufnahmebereich (1) eindringt, wenn zwischen dem ersten Substrat (2), dem zweiten Substrat (4) und dem dritten Substrat ein Druck angewendet wird, wobei sich zwischen den metallischen Materialien, welche den zusätzlichen Stift (7) beziehungsweise den zusätzlichen Aufnahmebereich (1) bilden, eine zusätzliche intermetallische Verbindung (5) bildet.

6. Vorrichtung, die Folgendes aufweist:
- ein erstes Substrat (2), das mit einem einstückigen Aufnahmebereich (1) aus einem ersten metallischen Material versehen ist, wobei der Aufnahmebereich (1) eine elektrische Verbindung bildet,
- ein zweites Substrat (4), das mit einem Einsteckbereich (3) versehen ist, wobei der Einsteckbereich (3) eine elektrische Verbindung bildet,
- wobei der Einsteckbereich (3) eine Grundfläche (6) bildet, aus welcher mindestens zwei Stifte (7), die aus einem zweiten metallischen Material sind, hinausragen,
- wobei die mindestens zwei Stifte (7) in ein- und demselben Aufnahmebereich (1) stecken, um zwischen dem ersten (2) und dem zweiten (4) Substrat eine mechanische und elektrische Verbindung zu bilden,
wobei:
- die Grundfläche (6) aus einem dritten metallischen Material gebildet ist, wobei die mindestens zwei Stifte (7) im Inneren der Grundfläche (6) stecken, wobei sie durch eine zweite intermetallische Verbindung (8) des dritten und des zweiten metallischen Materials von dem dritten metallischen Material getrennt sind, und wobei die Vorrichtung eine durchgehende Schicht einer intermetallischen Verbindung (5) des ersten und des zweiten metallischen Materials aufweist, die jeden der mindestens zwei Stifte (7) vom Aufnahmebereich (1) trennt, wobei die mindestens zwei Schichten der intermetallischen Verbindung durch einen Bereich aus dem ersten metallischen Material voneinander getrennt sind.

## Claims

1. A method for securing two substrates (2, 4) comprising the following steps:
- providing a first substrate (2) provided with a monoblock receiving area (1) made from a first metallic material and a second substrate (4) provided with an insertion area (3) comprising a base surface (6) and at least two bumps (7) made from a second metallic material, the at least two bumps (7) being salient from the base surface (6), the receiving area (1) et the insertion area (3) forming an electrical connection,
- applying a pressure between the first substrate (2) and the second substrate (4) so as to make the at least two bumps (7) penetrate into the receiving area (1) of the first substrate (2),
- making the first metallic material react with the second metallic material so as to form a continuous layer of an intermetallic compound (5) based on the first and second metallic materials along the interface between each bump (7) and the receiving area (1), the at least two layers of intermetallic compound being separated by an area made from the first metallic material, the base surface (6) being formed by a third metallic material, the at least two bumps (7) penetrating into the base surface (6) when applying the pressure, the third metallic material reacting with the second metallic material to form a second intermetallic compound (8).

2. The method according to claim 1, **characterized in that** heat treatment is performed during application of the pressure to make the first metallic material react with the second metallic material and make the second metallic material react with the third metallic material.

3. The method according to one of claims 1 to 2, **characterized in that** the hardness ratio between the second metallic material and the first metallic material is greater than or equal to two.

4. The method according to claim 2 or claim 3 depending on claim 2, **characterized in that** the heat treatment makes the first metallic material melt.

5. The method according to any one of claims 1 to 4, **characterized in that** a third substrate (10) is placed in contact with the first substrate (2) or with the second substrate (4) and **in that** either the third susbtrate or the substrate with which it is brought into contact comprises an additional receiving zone (1), the substrate which does not comprise said additional receiving zone comprising an additional insertion zone (3), at least one additional bump (7) of the additional insertion area (3) penetrating into the additional receiving area (1) when a pressure is applied between the first substrate (2), second substrate (4) and third substrate, an additional intermetallic compound (5) being formed between the metallic materials forming the additional bump (7) and the additional receiving area (1).

6. A device comprising:
- a first substrate (2) provided with a monoblock receiving area (1) made from a first metallic material, the receiving area (1) forming an electrical connection,
- a second substrate (4) provided with an insertion area (3), the insertion area (3) forming an electrical connection,
- the insertion area (3) comprising a base surface (6) from which at least two bumps (7) made from a second metallic material are salient,
- the at least two bumps (7) being inserted into the same receiving area (1) to form a mechanical and electric connection between the first (2) and second (4) substrate,
where the base surface (6) is formed by a third metallic material, the at least two bumps (7) are inserted into the base surface (6) and separated from the third metallic material by a second intermetallic compound made from second and third metallic materials and where the device comprises continuous layer of an intermetallic compound (5) made from the first and second metallic materials separating each of the at least two bumps (7) from the receiving area (1), the at least two layers of said intermetallic compound being separated by an area made from the first metallic material.
